# EUROPEAN PATENT APPLICATION

(11) **EP 4 307 851 A1**
(43) Date of publication of application: **17.01.2024**
(21) Application number: 21929940.1
(22) Date of filing: 02.12.2021
(51) Int. Cl.: H05K 9/00

(54) **ELECTRICAL EQUIPMENT**

(30) Priority: 10.03.2021 CN 202120507224 U
(71) Applicant: Sungrow Power Supply Co., Ltd., Hefei, Anhui 230088 (CN)
(72) Inventor: SHEN, Zhanliang, Hefei, Anhui 230088 (CN); LI, Yonghong, Hefei, Anhui 230088 (CN); LU, Yu, Hefei, Anhui 230088 (CN)
(74) Representative: Biallo, Dario
(86) International application number: PCT/CN2021/135032
(87) International publication number: WO 2022/188478

(57) **Abstract**

The present invention relates to the technical field of electrical technologies, and in particular to electrical equipment. The electrical equipment provided by the present invention comprises a box body, a device, and a sealing member having both an electromagnetic shielding function and a sealing function. The device is detachably fixed on the box body, the sealing member is disposed between the box body and the device, and the base surface of the device can be attached to the installation surface of the box body, such that the sealing member can ensure the sealing installation of the box body and the device, and can also enable the base surface of the device to be closely attached to the installation surface of the box body to ensure the electromagnetic shielding function of conductive contact between the box body and the device. In the case of ensuring the sealing performance by using the sealing member, the electrical equipment does not need to add additional conductive contact parts between the box body and the device to ensure the electromagnetic shielding function of the conductive contact between the box body and the device, thereby reducing the process difficulty, saving cost, causing no short circuit inside the box body, and ensuring the stable operation of the electrical equipment.

## Description

This application claims the priority to Chinese Patent Application No. 202120507224.7, titled "ELECTRICAL EQUIPMENT", filed with the China National Intellectual Property Administration on March 10, 2021, the entire disclosure of which is incorporated herein by reference.

### FIELD

The present application relates to the technical field of electrical technologies, and in particular to electrical equipment.

### BACKGROUND

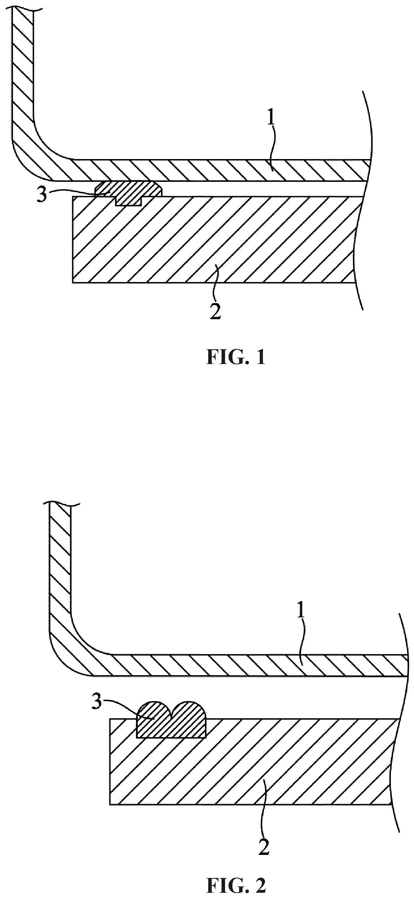

Generally, external devices such as reactors, heat dissipation devices, connectors, terminals, etc., are mounted on a box body of electrical equipment. In order to ensure the sealing of the box body of the electrical equipment, a sealing member is provided between the device and the box body. As shown in FIG. 1, the sealing member is generally placed in a mounting groove for mounting the device. After the device and the box body are securely mounted, the sealing member is clamped between a base surface of the device and the box body, thus a gap is kept between the device and the box body, which makes the device cannot be in effective contact with the box body, and thus the electromagnetic shielding function due to conductive contact cannot be realized. With the development of technology, in order to realize both sealing function and the electromagnetic shielding function due to conductive contact between the device and the box body, generally, a double-protrusion sealing member is used as shown in FIG. 2, in which one protrusion is used for electric conduction and the other protrusion is used for sealing. However, the process of this sealing member is complicated, and the protrusion for electric conduction needs to be provided with conductive filler, such as one of more of carbon, nickel, silver, etc., which is costly. Moreover, the protrusion for electric conduction is at risk of aging and brittle rupture after long-term use, and foreign matters caused by the rupture may lead to a short circuit of the electrical component inside the box body of the electrical equipment.

### SUMMARY

An object of the present application is to provide electrical equipment, the electrical equipment has a sealing member which not only ensures the sealed mounting between a box body and a device, but also ensures the electromagnetic shielding function between the box body and the device. The structure is simple in processing, which saves the cost, and can ensure the stable operation of the electrical equipment.

To achieve this object, the following technical solutions are provided according to the present application.

Electrical equipment includes:
a box body;
a device detachably fixed on the box body; and
a sealing member configured for electromagnetic shielding and sealing, where the sealing member is arranged between the box body and the device, a base surface of the device abuts against a mounting surface of the box body.

As a preferred solution, a mounting groove is defined on one of the base surface of the device and the mounting surface of the box body, the mounting groove includes a first groove section and a second groove section which are sequentially connected from top to bottom, a width of the first groove section is larger than a width of the second groove section , the sealing member is arranged in the second groove section, and a surface, away from the second groove section, of the sealing member is flush with an upper surface of the first groove section.

As a preferred solution, the sealing member is fixed in the second groove section by adhesive dispensing or adhesive layer bonding.

As a preferred solution, a stepped surface is provided on one of the base surface of the device and the mounting surface of the box body, a groove is defined on the stepped surface, the sealing member is arranged in the groove, and the sealing member is laid on the stepped surface, so that a surface, away from the groove, of the sealing member is flush with the base surface of the device or the mounting surface of the box body.

As a preferred solution, the sealing member is fixed in the groove by adhesive dispensing or adhesive layer bonding.

As a preferred solution, a stepped surface is provided on one of the base surface of the device and the mounting surface of the box body; the sealing member is arranged on the stepped surface, or the sealing member is arranged at a position, directly opposite to the stepped surface, of the other one of the base surface of the device and the mounting surface of the box body which is not provided with the stepped surface; and the sealing member is laid on the stepped surface, so that two surfaces of the sealing member abut against the mounting surface of the box body and the base surface of the device respectively.

As a preferred solution, the sealing member is fixed on the stepped surface or at the position, directly opposite to the stepped surface, of the other one of the base surface of the device and the mounting surface of the box body which is not provided with the stepped surface by adhesive dispensing or adhesive layer bonding.

As a preferred solution, both the box body and the device are conductors.

As a preferred solution, the mounting surface of the box body and the base surface of the device are in conductive contact.

As a preferred solution, the sealing member is a sealing rubber strip.

The beneficial effects of the present application are as follows.

In the electrical equipment according to the present application, by arranging the sealing member between the box body and the device, the sealing member is compressed under the fastening mounting between the box body and the device, so that the base surface of the device can abut against the mounting surface of the box body, and thus the sealing member can not only ensure the sealed mounting between the box body and the device, but also ensure the electromagnetic shielding function due to the conductive contact between the box body and the device. In the case of ensuring the sealing performance by using the sealing member in the electrical equipment, no additional components for conductive contact are required to be added between the box body and the device to ensure the electromagnetic shielding function due to conductive contact between the box body and the device, which reduces difficulty of the process, saves costs, and would not cause short-circuit phenomenon to the electrical components inside the box body, and thereby ensuring the stable operation of the electrical equipment.

### BRIEF DESCRIPTION OF THE DRAWINGS

FIG. 1 is a first schematic structural view of electrical equipment in conventional technology;
FIG. 2 is a second schematic structural view of electrical equipment in conventional technology;
FIG. 3 is a schematic structural view of electrical equipment in a case that a device is not mounted on a box body according to a first embodiment of the present application;
FIG. 4 is a schematic structural view of the electrical equipment in a case that the device is mounted on the box body according to the first embodiment of the present application;
FIG. 5 is a schematic structural view of electrical equipment in a case that a device is not mounted on a box body according to a second embodiment of the present application;
FIG. 6 is a schematic structural view of the electrical equipment in a case that the device is mounted on the box body according to the second embodiment of the present application;
FIG. 7 is a schematic structural view of electrical equipment in a case that a device is not mounted on a box body according to a third embodiment of the present application;
FIG. 8 is a schematic structural view of the electrical equipment in a case that the device is mounted on the box body according to the third embodiment of the present application; and
FIG. 9 is a schematic structural view of electrical equipment in a case that a device is not mounted on a box body according to a fourth embodiment of the present application.

**Reference numerals:**

| | | | |
|---|---|---|---|
| 1 | box body; | | |
| 2 | device; | 21 | mounting groove; |
| 211 | first groove section; | 212 | second groove section; |
| 22 | stepped surface; | 221 | groove; |
| 3 | sealing member. | | |

### DETAILED DESCRIPTION OF THE EMBODIMENTS

In order to make the technical problems to be solved by the present application, the technical solutions adopted and the technical effects achieved more clear, the technical solutions of the present application will be further illustrated hereinafter in conjunction with the drawings and embodiments.

In the description of the present application, unless otherwise clearly specified and limited, the terms "linked", "connected", and "fixed" shall be interpreted broadly, for example, may be interpreted as being fixedly connected, detachably connected, or integrated; the terms may be interpreted as being mechanically connected or electrically connected; the terms may also be interpreted as being directly connected or indirectly connected through an intermediate medium, the terms may further be interpreted as internal communication between two components or interactional relationship between two components. For those skilled in the art, the specific meanings of the terms in the present application may be understood in specific situations.

In the present application, unless otherwise clearly defined and limited, a first feature being "above" or "below" a second feature may include situations that the first and second features being in contact with each other directly, or the first and second features being in contact with each other indirectly via another feature between them. Furthermore, the first feature being "above", "over" or "on" the second feature includes that the first feature is directly above and obliquely above the second feature, or simply indicates that the first feature is higher in horizontal height than the second feature. The first feature being "below", "under" or "down" the second feature includes that the first feature is directly below and obliquely below the second feature, or simply means that the first feature is lower in horizontal height than the second feature.

In the description of the present application, the orientation or positional relationships indicated by terms "up", "down", "left", "right" and the like are based on the orientation or positional relationships shown in the drawings, and are merely for convenience of description and simplification of operation, which do not indicate or imply that the device or element referred to must be in a particular orientation, or be constructed and operated in a particular orientation, and therefore should not be construed as limitation to the present application. In addition, the terms "first" and "second" are only used for distinguishing of description and have no special meanings.

### First Embodiment

Electrical equipment is provided in this embodiment, the electrical equipment mainly refers to an inverter but is not limited thereto, which may also be other electrical equipment.

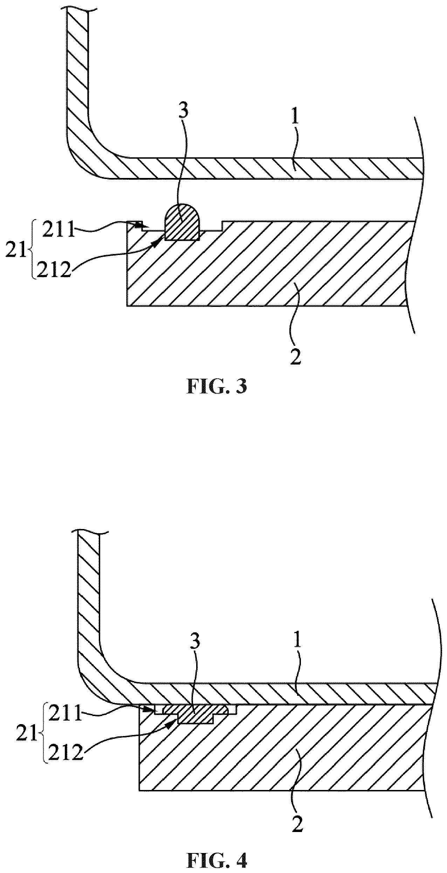

As shown in FIG. 3, the electrical equipment mainly includes a box body 1, a device 2 and a sealing member 3. The box body 1 plays a protecting and supporting role for electrical components inside the box body 1. The device 2 is an external device, which may be an electric reactor, a heat dissipation device, a connector, a terminal, etc.. The device 2 is detachably fixed on the box body 1, and is electrically connected with the electrical component inside the box body 1, so as to realize the function of the device 2. The sealing member 3 is arranged between the box body 1 and the device 2, so as to enhance the sealing of mounting between the device 2 and the box body 1. Specifically, a first mounting hole is defined in the device 2, a second mounting hole is defined in the box body 1, and a fastener passes through the first mounting hole and the second mounting hole sequentially to fix the device 2 on the box body 1. It should be noted that the fastener may be a screw, and the screwed connection is a detachable connection. In a case that the device 2 fails or is damaged, it is convenient to remove the damaged device 2 from the box body 1 for maintenance and replace it with a new device 2. In addition, the screwed connection has the advantages of strong reliability and stable mounting.

However, as shown in FIG. 1, the conventional sealing member 3 is generally placed in a mounting groove of the device 2. After the device 2 is securely mounted to the box body 1, the sealing member 3 is clamped between a base surface of the device 2 and the box body 1, thus a certain gap is formed between the device 2 and the box body 1, which makes the device 2 and the box body 1 cannot be in effective conductive contact, and thus the electromagnetic shielding function of the conductive contact cannot be realized.

With the development of technology, in order to ensure both sealing function and electromagnetic shielding function due to conductive contact between the device 2 and the box body 1, as shown in FIG. 2, a double-protrusion sealing member is generally adopted, in which one protrusion is used for electric conduction and the other protrusion is used for sealing. However, the process of this sealing member 3 is complicated, and the protrusion for electric conduction needs to be provided with conductive filler, such as one of more of carbon, nickel, silver, etc., which is costly. Moreover, the protrusion for electric conduction is at risk of aging and brittle rupture after long-term use, and foreign matters caused by the rupture may lead to a short circuit of the electrical component inside the box body 1 of the electrical equipment.

In order to solve the above problems, as shown in FIG. 3 and FIG. 4, the sealing member 3 of the electrical equipment in this embodiment has both the electromagnetic shielding function and the sealing function, and the sealing member 3 is arranged between the box body 1 and the device 2. After the device 2 and the box body 1 are securely mounted, the sealing member 3 is compressed, so that the base surface of the device 2 and the mounting surface of the box body 1 can abut against each other, and the sealing member 3 can not only ensure the sealing mounting between the box body 1 and the device 2, but also ensure the electromagnetic shielding function of the conductive contact between the box body 1 and the device 2. In the case of ensuring the sealing performance by using the sealing member 3, no additional components for conductive contact are required to be added between the box body 1 and the device 2 to ensure the electromagnetic shielding function due to the conductive contact between the box body 1 and the device 2, which reduces difficulty of the process, saves the cost, and would not cause short-circuit phenomenon to the electrical components inside the box body 1, and thereby ensuring the stable operation of the electrical equipment.

In this embodiment, both the box body 1 and the device 2 are conductors, to ensure the conductive contact between the box body 1 and the device 2, thereby ensuring the electromagnetic shielding function due to the conductive contact between the box body 1 and the device 2. Specifically, the box body 1 and the device 2 may be a metal piece, such as a sheet metal piece, a die-casting piece, a metal machined piece, or a non-metal piece coated with a conductive coating on the surface, to ensure that the box body 1 and the device 2 can form conductive cavities respectively after being in contact with each other.

It should be noted that, in other embodiments, the mounting surface of the box body 1 and the base surface of the device 2 are in conductive contact, as long as the limited contact portion between the box body 1 and the device 2 is ensured to be in conductive contact.

The specific placement of the sealing member 3 is described with reference to FIG. 3 and FIG. 4. As shown in FIG. 2 and FIG. 3, a mounting groove 21 is defined on the base surface of the device 2, the mounting groove 21 includes a first groove section 211 and a second groove section 212 which are sequentially connected from top to bottom, a width of the first groove section 211 is larger than a width of the second groove section 212, and the sealing member 3 is arranged in the second groove section 212. After the device 2 and the box body 1 are securely mounted, the sealing member 3 is compressed, so that a surface, away from the second groove section 212, of the sealing member 3 is flush with an upper surface of the first groove section 211, thereby ensuring that the base surface of the device 2 abuts against the mounting surface of the box body 1. It should be noted that, in other embodiments, alternatively, the mounting groove 21 may be defined on the mounting surface of the box body 1.

Preferably, the sealing member 3 may be a sealing rubber strip, the sealing rubber strip has a relatively large deformation amount, which is convenient to be laid on the first groove section 211 under the compressing effect of the device 2 and the box body 1, so as to ensure that the surface, away from the second groove section 212, of the sealing member 3 is flush with the upper surface of the first groove section 211. In addition, the sealing rubber strip has the advantages of low cost, high reliability and good realizability.

Preferably, the sealing rubber strip may be fixed in the second groove section 212 by adhesive dispensing, which can prevent the sealing rubber strip from falling off from the second groove section 212, so as to improve the stability of fixation between the sealing rubber strip and the second groove section 212. In other embodiments, the sealing rubber strip may be fixed in the second groove section 212 by adhesive layer bonding.

### Second Embodiment

The structure of the electrical equipment in this embodiment is substantially the same as that in the first embodiment. The difference between the electrical equipment in this embodiment and the first embodiment lies in the mounting form of the sealing member 3.

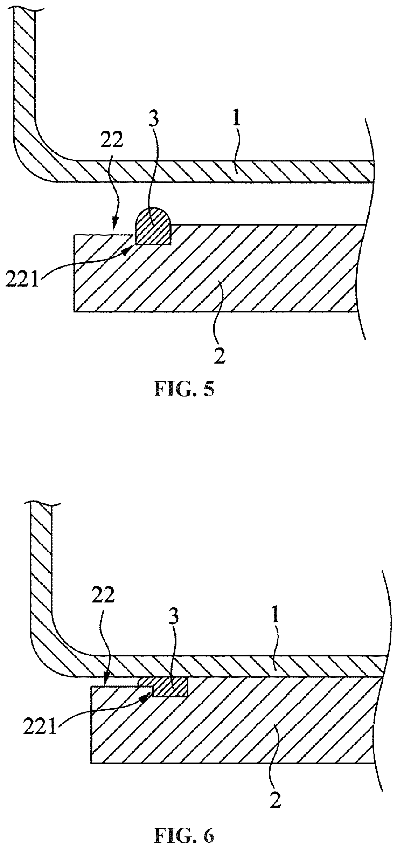

As shown in FIG. 5 and FIG. 6, a stepped surface 22 is provided on the base surface of the device 2, a groove 221 is defined on the stepped surface 22, and the sealing member 3 is arranged in the groove 221. After the device 2 and the box body 1 are securely mounted, the sealing member 3 is compressed, so that the sealing member 3 is laid on the stepped surface 22, and a surface, away from the groove 221, of the sealing member 3 is flush with the base surface of the device 2, thereby ensuring that the base surface of the device 2 abuts against the mounting surface of the box body 1. It should be noted that, in other embodiments, alternatively, the stepped surface 22 may be provided on the mounting surface of the box body 1. After the device 2 and the box body 1 are securely mounted, the sealing member 3 is compressed, so that the sealing member 3 is laid on the stepped surface 22, and a surface, away from the groove 221, of the sealing member 3 is flush with the mounting surface of the box body 1.

Preferably, the sealing member 3 may be fixed in the groove 221 by adhesive dispensing, which can prevent the sealing member 3 from falling off from the groove 221, thereby improving the stability of fixation between the sealing member 3 and the groove 221. In other embodiments, the sealing member 3 may be fixed in the groove 221 by adhesive layer bonding.

### Third Embodiment

The structure of the electrical equipment in this embodiment is substantially the same as that of the first embodiment. The difference between the electrical equipment in this embodiment and the first embodiment lies in the mounting form of the sealing member 3.

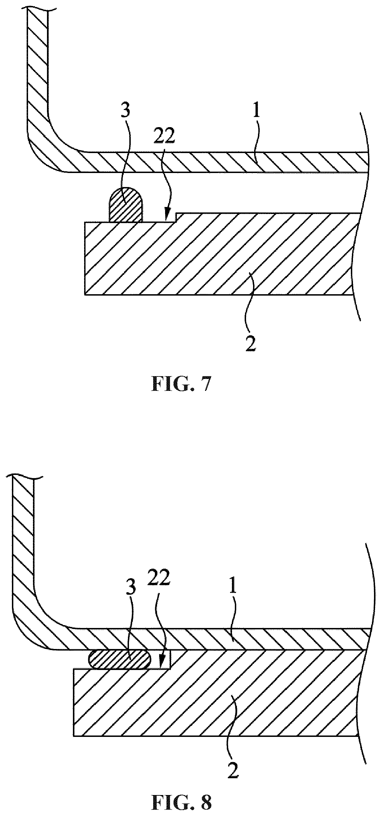

As shown in FIG. 7 and FIG. 8, a stepped surface 22 is provided on the base surface of the device 2, and the sealing member 3 is arranged on the stepped surface 22. After the device 2 and the box body 1 are securely mounted, the sealing member 3 is compressed, so that the sealing member 3 is laid on the stepped surface 22, and a surface, away from the stepped surface 22, of the sealing member 3 is flush with the base surface of the device 2, thereby ensuring that the base surface of the device 2 abuts against the mounting surface of the box body 1. It should be noted that, in other embodiments, alternatively, a stepped surface 22 is provided on the mounting surface of the box body 1. After the device 2 and the box body 1 are securely mounted, the sealing member 3 is compressed, so that the sealing member 3 is laid on the stepped surface 22, and a surface, away from the stepped surface 22, of the sealing member 3 is flush with the mounting surface of the box body 1.

Preferably, the sealing member 3 is fixed on the stepped surface 22 by adhesive dispensing, which can prevent the sealing member 3 from falling off from the stepped surface 22, and thereby improving the stability of fixation between the sealing member 3 and the stepped surface 22. In other embodiments, the sealing member 3 may be fixed on the stepped surface 22 by adhesive layer bonding.

### Fourth Embodiment

The structure of the electrical equipment in this embodiment is substantially the same as that of the third embodiment. The difference between the electrical equipment in this embodiment and the third embodiment lies in: the mounting position of the sealing member 3.

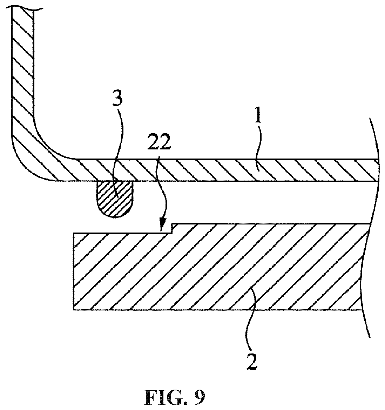

As shown in FIG. 9, a stepped surface 22 is provided on the base surface of the device 2, the sealing member 3 is arranged on the box body 1, and the sealing member 3 is directly opposite to the stepped surface 22. After the device 2 and the box body 1 are securely mounted, the sealing member 3 is compressed, so that the sealing member 3 is laid on the stepped surface 22, and two surfaces of the sealing member 3 respectively abut against the mounting surface of the box body 1 and the base surface of the device 2, thereby ensuring that the base surface of the device 2 abuts against the mounting surface of the box body 1. It should be noted that, in other embodiments, alternatively, the stepped surface 22 may be provided on the mounting surface of the box body 1, the sealing member 3 is arranged on the device 2, and the sealing member 3 is directly opposite to the stepped surface 22.

Preferably, the sealing member 3 is fixed on the box body 1 by adhesive dispensing, which can prevent the sealing member 3 from falling off from the box body 1, and thereby improving the stability of fixation between the sealing member 3 and the box body 1. In other embodiments, the sealing member 3 may be fixed on the box body 1 by adhesive layer bonding.

Obviously, the above embodiments of the present application are merely examples for clearly illustrating the present application, and are not intended to limit the implementations of the present application. For those skilled in the art, other changes or modifications in different forms may be made on the basis of the above illustration. It is unnecessary and impossible to list all the implementations herein. Any modification, equivalent replacement and improvement made within the spirit and principle of the present application are deemed to fall into the protection scope of claims of the present application.

## Claims

1. Electrical equipment, comprising:
a box body (1);
a device (2) detachably fixed on the box body (1); and
a sealing member (3) configured for electromagnetic shielding and sealing, wherein the sealing member (3) is arranged between the box body (1) and the device (2), a base surface of the device (2) abuts against a mounting surface of the box body (1).

2. The electrical equipment according to claim 1, wherein a mounting groove (21) is defined on one of the base surface of the device (2) and the mounting surface of the box body (1), the mounting groove (21) comprises a first groove section (211) and a second groove section (212) which are sequentially connected from top to bottom, a width of the first groove section (211) is larger than a width of the second groove section (212), the sealing member (3) is arranged in the second groove section (212), and a surface, away from the second groove section (212), of the sealing member (3) is flush with an upper surface of the first groove section (211).

3. The electrical equipment according to claim 2, wherein the sealing member (3) is fixed in the second groove section (212) by adhesive dispensing or adhesive layer bonding.

4. The electrical equipment according to claim 1, wherein a stepped surface (22) is provided on one of the base surface of the device (2) and the mounting surface of the box body (1), a groove (221) is defined on the stepped surface (22), the sealing member (3) is arranged in the groove (221), and the sealing member (3) is laid on the stepped surface (22), to make a surface, away from the groove (221), of the sealing member (3) to be flush with the base surface of the device (2) or the mounting surface of the box body (1).

5. The electrical equipment according to claim 4, wherein the sealing member (3) is fixed in the groove (221) by adhesive dispensing or adhesive layer bonding.

6. The electrical equipment according to claim 1, wherein a stepped surface (22) is provided on one of the base surface of the device (2) and the mounting surface of the box body (1);
the sealing member (3) is arranged on the stepped surface (22); or, the sealing member (3) is arranged at a position, directly opposite to the stepped surface (22), of the other one of the base surface of the device (2) and the mounting surface of the box body (1) which is not provided with the stepped surface (22); and
the sealing member (3) is laid on the stepped surface (22), and two surfaces of the sealing member (3) abut against the mounting surface of the box body (1) and the base surface of the device (2) respectively.

7. The electrical equipment according to claim 6, wherein the sealing member (3) is fixed on the stepped surface (22) or at the position, directly opposite to the stepped surface (22), of the other one of the base surface of the device (2) and the mounting surface of the box body (1) which is not provided with the stepped surface (22) by adhesive dispensing or adhesive layer bonding.

8. The electrical equipment according to any one of claims 1 to 7, wherein both the box body (1) and the device (2) are conductors.

9. The electrical equipment according to any one of claims 1 to 7, wherein the mounting surface of the box body (1) and the base surface of the device (2) are in conductive contact.

10. The electrical equipment according to any one of claims 1 to 7, wherein the sealing member (3) is a sealing rubber strip.
